# EUROPEAN PATENT SPECIFICATION

(11) **EP 3 156 249 B1**
(45) Date of publication and mention of the grant of the patent: **12.12.2018**
(21) Application number: 15806078.0
(22) Date of filing: 27.05.2015
(51) Int. Cl.: B41N 1/12, B41C 1/05, G03F 7/00

(54) **FLEXOGRAPHIC PRINTING ORIGINAL PLATE FOR LASER ENGRAVING AND FLEXOGRAPHIC PRINTING PLATE**
FLEXODRUCKORIGINALPLATTE FÜR LASERGRAVUR UND FLEXODRUCKPLATTE
PLAQUE ORIGINALE D'IMPRESSION FLEXOGRAPHIQUE POUR GRAVURE AU LASER ET PLAQUE D'IMPRESSION FLEXOGRAPHIQUE

(30) Priority: 11.06.2014 JP 2014120836
(43) Date of publication of application: 19.04.2017
(73) Proprietor: Fujifilm Corporation, Minato-ku Tokyo 106-8620 (JP)
(72) Inventor: NAMBA, Yusuke, Shizuoka 421-0396 (JP)
(74) Representative: Hoffmann Eitle
(86) International application number: PCT/JP2015/065246
(87) International publication number: WO 2015/190295

(56) References cited:
- JP-A- 2001 209 169
- JP-A- 2009 190 264
- JP-A- 2011 136 429
- US-A1- 2013 000 503
- US-B1- 7 841 277
- US-B2- 7 223 524

## Description

### BACKGROUND OF THE INVENTION

### 1. Field of the Invention

The present invention relates to a flexographic printing plate precursor for laser engraving and a flexographic printing plate.

### 2. Description of the Related Art

Flexographic printing is a printing method of applying an ink to projections on the form of a printing plate by using an anilox roller or the like and transferring the ink to a printing material. As a flexographic printing plate used in flexographic printing, a printing plate, which is obtained by directly engraving a flexographic printing plate precursor by using a laser, or the like is used.

For example, JP2011-136429A discloses a relief printing plate precursor for laser engraving (flexographic printing plate precursor for laser engraving) obtained by forming a relief forming layer (resin layer) on a support by using a resin composition for laser engraving, which contains a compound having a hydrolyzable silyl group and/or a silanol group, a polymer containing a conjugated diene monomer unit, and a vulcanizing agent, and making the relief forming layer into a cross-linked relief forming layer through thermal cross-linking. JP2011-136429A also discloses a relief printing plate (flexographic printing plate) obtained by laser-engraving the precursor.

US 7,841,277 B1 relates to a printing structure for printing on a medium that includes a first layer having an outer surface adapted to receive ink for printing on the medium, the first layer having a first hardness and/or a first surface energy; and a second layer positioned outside of the first layer, the second layer having an outer surface adapted to receive ink for printing on the medium and the second layer having a second hardness which is less than the first hardness and/or a second surface energy which is greater than the first surface energy, and portions of the second layer are removed to expose the outer surface of the first layer.

US 7,223,524 B2 relates to a laser-engravable flexographic printing element, the relief-forming layer of which comprises a conductivity carbon black having a specific surface area of at least 150 m²/g and a DBP number of at least 150 ml/100 g. It also describes a method for producing flexographic printing plates in which a printing relief is engraved into said flexographic printing element by means of a laser system.

JP 2009-190264 A describes a printing plate in which a resin layer is subjected to laser engraving, so as to form an image part. The resin layer is provided with a surface layer at which the image part is arranged and a supporting layer laminated at the inside of the surface layer and having a hardness different from that of the surface layer, and is composed of at least two layers.

### SUMMARY OF THE INVENTION

It is required that a flexographic printing plate is excellent in the quality of a solid portion (solid quality). More specifically, it is required that the density of the solid portion is uniform when the printing plate is subjected to indentation.

Furthermore, it is required that an increase of density of halftone dots (dot gain) is small when printing pressure is applied to the printing plate. That is, it is required that the density of halftone dots changes little (printing pressure latitude is wide) even if the printing pressure is changed. Herein, the printing pressure is generally represented by an indentation amount [µm] of the printing plate.

The inventor of the present invention examined the flexographic printing plate precursor for laser engraving disclosed in JP2011-136429A. As a result, it became evident that the obtained flexographic printing plate is not always able to achieve solid quality and printing pressure latitude at a high level.

An object of the present invention based on the above circumstances is to provide a flexographic printing plate precursor for laser engraving which makes it possible to obtain a flexographic printing plate having excellent solid quality and a wide printing pressure latitude and a flexographic printing plate which is obtained by laser-engraving the flexographic printing plate precursor for laser engraving.

As a result of conducting intensive examination regarding the above object, the present inventor obtained knowledge that the above object can be achieved by making a flexographic printing plate precursor for laser engraving including two resin layers whose dynamic hardnesses satisfy a specific relationship. Based on the knowledge, the inventor accomplished the present invention.

That is, the inventor of the present invention found that the above object can be achieved by the following constitution.

(1) A flexographic printing plate precursor for laser engraving including a first resin layer formed from a composition containing a diene-based polymer, a second resin layer formed from a composition containing a diene-based polymer, and a support in this order, in which a thickness of the first resin layer is equal to or less than 0.03 mm, and a ratio of a dynamic hardness of the first resin layer to a dynamic hardness of the second resin layer is equal to or less than 0.3.
(2) The flexographic printing plate precursor for laser engraving described in (1), in which the thickness of the first resin layer is equal to or less than 0.02 mm.
(3) The flexographic printing plate precursor for laser engraving described in (1) or (2), in which the first resin layer is a resin layer obtained by cross-linking a composition for forming a first resin layer containing a diene-based polymer, a photothermal conversion agent, and a cross-linking agent, and the second resin layer is a resin layer obtained by cross-linking a composition for forming a second resin layer containing a diene-based polymer, a photothermal conversion agent, and a cross-linking agent.
(4) A flexographic printing plate obtained by laser-engraving the flexographic printing plate precursor for laser engraving described in any one of (1) to (3).

As will be described below, according to the present invention, it is possible to provide a flexographic printing plate precursor for laser engraving which makes it possible to obtain a flexographic printing plate having excellent solid quality and a wide printing pressure latitude and a flexographic printing plate which is obtained by laser-engraving the flexographic printing plate precursor for laser engraving.

### BRIEF DESCRIPTION OF THE DRAWINGS

Fig. 1 is a schematic sectional view of an embodiment of a flexographic printing plate precursor for laser engraving of the present invention.
Fig. 2 is an image for evaluation used in examples.

### DESCRIPTION OF THE PREFERRED EMBODIMENTS

Hereinafter, a flexographic printing plate precursor for laser engraving and a flexographic printing plate of the present invention will be described.

In the present specification, a range of numerical values described using "to" means a range having numerical values listed before and after "to" as a lower limit and an upper limit.

### [Flexographic printing plate precursor for laser engraving]

The flexographic printing plate precursor for laser engraving of the present invention (hereinafter, referred to as a flexographic printing plate precursor of the present invention or a precursor of the present invention as well) includes a first resin layer, a second resin layer, and a support in this order as defined in claim 1. A thickness of the first resin layer is equal to or less than 0.03 mm, and a ratio of a dynamic hardness of the first resin layer to a dynamic hardness of the second resin layer is equal to or less than 0.3.

It is considered that, because of being constituted as above, the precursor of the present invention makes it possible to obtain a flexographic printing plate which has excellent solid quality and a wide printing pressure latitude. The reason is unclear but is presumed to be as below.

That is, it is considered that, because the precursor of the present invention includes a (soft) resin layer (first resin layer) having a small hardness as a surface layer and a (hard) resin layer (second resin layer) having a great hardness as an underlayer of the soft resin layer, the soft surface layer in the obtained printing plate is uniformly crushed when the printing plate is subjected to indentation, and hence excellent solid quality is exhibited. Furthermore, it is considered that, due to the presence of the hard underlayer, halftone dots are prevented from being greatly deformed, and a printing pressure latitude widens. It is considered that, as a result, both of the solid quality and the printing pressure latitude are achieved at a high level.

As will be described later, by engraving the precursor of the present invention from the first resin layer side, a flexographic printing plate including a relief layer and a support can be made.

The precursor of the present invention may include other layers between each of the resin layers and the support, but it is preferable that the first resin layer and the second resin layer are adjacent to each other.

First, the precursor of the present invention will be described using a drawing.

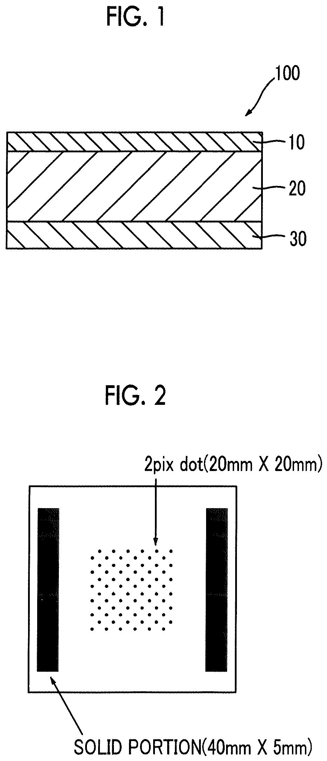

Fig. 1 is a schematic sectional view of an embodiment of the flexographic printing plate precursor for laser engraving of the present invention.

A flexographic printing plate precursor for laser engraving 100 includes a first resin layer 10, a second resin layer 20, and a support 30 in this order as defined in claim 1. A thickness of the first resin layer 10 is equal to or less than 0.03 mm. A ratio of a dynamic hardness of the first resin layer 10 to a dynamic hardness of the second resin layer 20 is equal to or less than 0.3.

Hereinafter, each of the resin layers and the support will be described.

### [First resin layer]

The first resin layer is formed from a composition containing a diene-based polymer and is a resin layer which has a thickness of equal to or less than 0.03 mm and satisfies a ratio (D1/D2) which will be described later. The first resin layer is preferably a rubber layer.

A lower limit of the thickness of the first resin layer is not particularly limited, but is preferably equal to or greater than 0.001 mm, more preferably equal to or greater than 0.002 mm, even more preferably equal to or greater than 0.005 mm, and particularly preferably equal to or greater than 0.01 mm.

The thickness of the first resin layer is preferably equal to or less than 0.02 mm.

If the thickness of the first resin layer is greater than 0.03 mm, a printing pressure latitude of the obtained flexographic printing plate narrows.

The first resin layer is preferably a resin layer obtained by cross-linking a composition for forming a first resin layer that will be described later. That is, the first resin layer contains a diene-based polymer, which will be described later, or a cross-linked substance thereof and a photothermal conversion agent which will be described later.

### [Second resin layer]

The second resin layer is formed from a composition containing a diene-based polymer and is a resin layer satisfying a ratio (D1/D2) which will be described later. The second resin layer is preferably a rubber layer.

A thickness of the second resin layer is not particularly limited, but is preferably 0.5 to 10 mm and more preferably 0.6 to 3 mm.

The second resin layer is preferably a resin layer obtained by cross-linking a composition for forming a second resin layer that will be described later. That is, the second resin layer contains a diene-based polymer, which will be described later, or a cross-linked substance thereof and a photothermal conversion agent which will be described later.

A ratio (D1/D2) of a dynamic hardness (D1) of the first resin layer to a dynamic hardness (D2) of the second resin layer is equal to or less than 0.3. It is considered that, because the ratio (D1/D2) is equal to or less than 0.3 in the precursor of the present invention, the obtained flexographic printing plate exhibits excellent solid quality.

A lower limit of the ratio (D1/D2) is not particularly limited, but is preferably equal to or greater than 0.1.

The dynamic hardness (D1) of the first resin layer is preferably equal to or greater than 0.1 N/mm² and less than 5 N/mm², and more preferably equal to or greater than 1 N/mm² and equal to or less than 3 N/mm².

The dynamic hardness (D2) of the second resin layer is preferably equal to or greater than 5 N/mm² and equal to or less than 20 N/mm², and more preferably equal to or greater than 6 N/mm² and equal to or less than 10 N/mm².

In the present specification, a dynamic hardness [N/mm²] of each resin layer is measured under the following conditions.
- Measurement instrument: PICODENTOR HM500 manufactured by Fischer Technology, Inc.
- Indenter: Vickers indenter (pyramidal diamond indenter with an angle between opposite faces of 136°)
- Rate of indentation: 0.83 mN/sec
- Depth of indentation: 1 µm
- Measurement temperature: 25°C

The dynamic hardness of the first resin layer is measured in a direction perpendicular to a surface of the precursor on the first resin layer side. Furthermore, the dynamic hardness of the second resin layer is obtained by cutting the precursor in a direction perpendicular to a surface thereof so as to obtain a section and measuring the dynamic hardness in a direction perpendicular to the obtained section.

### [Support]

The support is not particularly limited, but it is preferable to use a support having high dimensional stability. Examples of a material thereof include a metal such as steel, stainless steel, or aluminum, polyester (for example, polyethylene terephthalate (PET), polybutylene terephthalate (PBT), or polyacrylonitrile (PAN)); a plastic resin such as polyvinyl chloride; synthetic rubber such as styrene-butadiene rubber; a plastic resin (an epoxy resin, a phenol resin, or the like) reinforced with glass fiber; and the like.

As the support, a PET film or a steel substrate is preferably used.

A thickness of the support is not particularly limited, but is preferably 10 to 1,000 µm.

### [Other layers]

As described above, the precursor of the present invention may include other layers between each of the resin layers and the support.

For example, from the viewpoint of enhancing adhesion between the second resin layer and the support, an adhesive layer may be provided.

As a material (adhesive) which can be used in the adhesive layer, for example, it is possible to use those described in "Handbook of Adhesives" edited by I. Skeist, 2nd edition (1997).

As described above, it is preferable that the first resin layer and the second resin layer are adjacent to each other.

### [Method for manufacturing flexographic printing plate precursor for laser engraving]

A method for manufacturing the precursor of the present invention is not particularly limited, and examples of a preferred aspect of the method include a method including the following steps (1) to (5).
(1) A first resin layer precursor layer forming step of forming a first resin layer precursor layer by using a composition for forming a first resin layer containing a diene-based polymer, a photothermal conversion agent, and a cross-linking agent
(2) A second resin layer precursor layer forming step of forming a second resin layer precursor layer by using a composition for forming a second resin layer containing a diene-based polymer, a photothermal conversion agent, and a cross-linking agent
(3) A relief forming layer forming step of forming a relief forming layer by bonding the first resin layer precursor layer and the second resin layer precursor layer to each other
(4) A cross-linking step of cross-linking the relief forming layer by heating so as to form a cross-linked relief forming layer (the first resin layer + the second resin layer)
(5) Support bonding step of bonding a support to the second resin layer side of the cross-linked relief forming layer so as to manufacture a flexographic printing plate precursor for laser engraving

Hereinafter, each step will be described.

### <Step (1): first resin layer precursor layer forming step>

The first resin layer precursor layer forming step is a step of forming a first resin layer precursor layer (first resin sheet) by using a composition for forming a first resin layer containing a diene-based polymer, a photothermal conversion agent, and a cross-linking agent.

First, each component contained in the composition for forming a first resin layer will be described.

### (Diene-based polymer)

The diene-based polymer contained in the composition for forming a first resin layer is not particularly limited, and diene-based polymers known in the related art can be used without limitation.

Specific examples of the diene-based polymer include polyisoprene, polybutadiene, an ethylene-propylene-diene copolymer (EPDM), an acrylonitrile-butadiene copolymer, a styrene-butadiene copolymer (SBR), a styrene-isoprene copolymer, a styrene-isoprene-butadiene copolymer, and the like. One kind of these may be used singly, or two or more kinds thereof may be used in combination.

Among these, at least one kind of diene-based polymer selected from the group consisting of polyisoprene, polybutadiene, and an ethylene-propylene-diene copolymer is preferable because such a polymer reduces variation of the thickness of the precursor.

In the present invention, polyisoprene or polybutadiene should be a polymer whose main chain mainly consists of isoprene or butadiene as a monomer unit. Furthermore, a portion of the polyisoprene or the polybutadiene may be hydrogenated and converted into a saturated bond. In addition, the middle or terminal of the main chain of the polymer may be denatured with amide, a carboxy group, a hydroxy group, a (meth)acryloyl group, or the like or may be epoxylated.

In the present specification, a (meth)acryloyl group refers to an acryloyl group or a methacryloyl group.

In the present invention, a proportion of a monomer unit derived from aliphatic hydrocarbon (isoprene, butadiene, or a hydrogenated substance thereof) in a main chain of polyisoprene or polybutadiene is preferably equal to or greater than 80 mol%.

It is preferable that the proportion of a monomer unit derived from aliphatic hydrocarbon in the main chain is equal to or greater than 80 mol%, because then rinsing properties of engraving residues become excellent.

A content of the monomer unit derived from aliphatic hydrocarbon is preferably equal to or greater than 90 mol%, more preferably 95 mol%, and particularly preferably equal to or greater than 99 mol%, with respect to a total amount of monomer units constituting the main chain of the diene-based polymer.

In the present invention, a "main chain" means the relatively longest bonding chain in a molecule of a polymer compound constituting a resin, and a "side chain" means a carbon chain branched from the main chain. The side chain may contain a heteroatom.

That is, for example, in polyisoprene, a proportion of a monomer unit derived from a isoprene and a hydrogenated substance of isoprene is preferably equal to or greater than 80 mol% in total, more preferably equal to or greater than 90 mol% in total, even more preferably equal to or greater than 95 mol% in total, and particularly preferably equal to or greater than 99 mol% in total.

Similarly, in polybutadiene, a proportion of a monomer unit derived from butadiene and a hydrogenated substance of butadiene is preferably equal to or greater than 80 mol% in total, more preferably equal to or greater than 90 mol% in total, even more preferably equal to or greater than 95 mol% in total, and particularly preferably equal to or greater than 99 mol% in total.

In a case where an isoprene-butadiene copolymer is used as the diene-based polymer, the copolymer contains a monomer unit derived from isoprene, butadiene, and a hydrogenated substance thereof, preferably in an amount of equal to or greater than 80 mol% in total, more preferably in an amount of equal to or greater than 90 mol% in total, even more preferably in an amount of equal to or greater than 95 mol% in total, and particularly preferably in an amount of equal to or greater than 99 mol% in total.

Isoprene is known to be polymerized by 1,2-, 3,4-, or 1,4- addition depending on the type of catalyst or reaction conditions. In the present invention, polyisoprene polymerized by the any of the above addition modes may be used. From the viewpoint of obtaining a desired Mooney viscosity, among the isoprene compounds, it is preferable that cis-1,4-polyisoprene is contained as a main component. A content of the cis-1,4-polyisoprene is preferably equal to or greater than 50% by mass, more preferably equal to or greater than 65% by mass, even more preferably equal to or greater than 80% by mass, and particularly preferably equal to or greater than 90% by mass.

As polyisoprene, natural rubber or commercially available polyisoprene can be used, and examples thereof include a NIPOL IR series (manufactured by ZEON CORPORATION).

Butadiene is known to polymerized by 1,2 or 1,4- addition depending on the type of catalyst or reaction conditions. In the present invention, polybutadiene polymerized by any of the above addition modes may be used. From the viewpoint of obtaining a desired Mooney viscosity, among the butadiene compounds, 1,4-polybutadiene is more preferably a main component.

A content of the 1,4-polybutadiene is preferably equal to or greater than 50% by mass, more preferably equal to or greater than 65% by mass, even more preferably equal to or greater than 80% by mass, and particularly preferably equal to or greater than 90% by mass.

A content of a cis-isomer and a trans-isomer is not particularly limited and may be appropriately selected within a range of a desired Mooney viscosity. From the viewpoint of bring about rubber elasticity, a cis-isomer is preferable. A content of cis-1,4-polybutadiene is preferably equal to or greater than 50% by mass, more preferably equal to or greater than 65% by mass, even more preferably equal to or greater than 80% by mass, and particularly preferably equal to or greater than 90% by mass.

Commercially available polybutadiene may be used, and examples thereof include a NIPOL BR series (manufactured by ZEON CORPORATOIN), a UBEPOL BR series (manufactured by UBE INDUSTRIES, LTD.), and the like.

The ethylene-propylene-diene copolymer (EPDM) is preferably a polymer having a Mooney viscosity ML₁₊₄ (100°C) of 25 to 90. The Mooney viscosity ML₁₊₄ (100°C) is a value measured based on the stipulation of ASTM D1646.

EPDM is preferably a polymer in which an ethylene content is 40 to 70% by mass and a diene content is 1 to 20% by mass.

Examples of the diene component of EPDM include dicyclopentadienen (DCPD), 5-ethylidene-2-norbornene, 1,4-hexadiene, and the like.

In the present invention, a weight-average molecular weight of the diene-based polymer is preferably equal to or greater than 200,000, more preferably 300,000 to 2,000,000, even more preferably 300,000 to 1,500,000, and particularly preferably 300,000 to 700,000.

The weight-average molecular weight is measured by a gel permeation chromatography (GPC) method and expressed in terms of standard polystyrene. Specifically, for example, HLC-8220GPC (manufactured by Tosoh Corporation) is used as a GPC device, three columns consisting of TSKgeL Super HZM-H, TSKgeL SuperHZ 4000, and TSKgeL SuperHZ2000 (manufactured by Tosoh Corporation, 4.6 mmID × 15 cm) are used as columns, and tetrahydrofuran (THF) is used as an eluent. GPC is performed using an IR detector under the conditions of a sample concentration of 0.35% by mass, a flow rate of 0.35 mL/min, a sample injection amount of 10 µL, and a measurement temperature of 40°C. Furthermore, a calibration curve is prepared from eight samples of "standard sample TSK standard, polystyrene": "F-40", "F-20", "F-4", "F-1", "A-5000", "A-2500", "A-1000", and "n-propylbenzene" manufactured by Tosoh Corporation.

In the present invention, from the viewpoint of printin durability, a Mooney viscosity of the diene-based polymer is preferably equal to or greater than 20, more preferably equal to or greater than 25, and even more preferably equal to or greater than 35.

Similarly, in view of solvent solubility or ease of handling at the time of mixing, a Mooney viscosity of the diene-based polymer is preferably equal to or less than 90, more preferably equal to or less than 70, and evenm ore preferably equal to or less than 60.

The mooney viscosity is a value measured based on JIS 6300-1. Specifically, by forming a cylindrical space between temperature-controllable dies, a sample chamber is prepared. Furthermore, a rotor is disposed in a central portion of the sample chamber, and the sample chamber is filled with a sample to be measured. In a state where a temperature of the chamber is being kept at a predetermined temperature, the rotor is rotated at a preset number of revolution. By detecting anti torque of the rotor, which results from viscous resistance of the molten sample, by using a load cell, the Mooney viscosity is measured. Herein, the value of Mooney viscosity used in the present invention repersents a Mooney viscosity (ML 1 + 4) of a rubber sample that is measured after an L-type rotor is rotated for 4 minuets under the condition of preheating the sample for 1 minute at 100°C.

In the composition for forming a first resin layer, a content of the diene-based polymer is preferably 10 to 95% by mass and more preferably 50 to 92% by mass, with respect to a total amount of nonvolatile components (having a boiling point of equal to or higher than 120°C). It is preferable that the content of the diene-based polymer is within the above range, because then rinsing properties of engraving residues become excellent, and a relief layer having excellent ink transferability is obtained.

### (Photothermal conversion agent)

The photothermal conversion agent (photothermal conversion material) contained in the composition for forming a first resin layer is considered as a component which accelerates thermal decomposition of a cured material at the time of laser engraving by absorbing laser beam and releasing heat.

Therefore, it is preferable to select a photothermal conversion material absorbing light having a wavelength of the laser used for engraving.

For example, in a case where the precursor of the present invention is used for laser engraving using a laser (a YAG laser, a semiconductor laser, a fiber laser, a surface emitting layser, or the like) that emits infrared rays at 700 to 1,300 nm as a light source, as a photothermal conversion material, it is preferable to use a compound having a maximum absorption wavelength at 700 to 1,300 nm.

As such a photothermal conversion material, variuos dyes or pigments are used.

Among the phototheral conversion materials, as dyes, it is possible to use commercially available dyes and known dyes described in documents such as "Handbook of dyes" (editied by The Society of Synthetic Organic Chemistry, Japan, 1970). Specifically, examples thereof include dyes having a maximum absorption wavelength at 700 to 1,300 nm. Examples thereof preferably niclude dyes such as an azo dye, a metal complex azo dye, a pyrazolon azo dye, a naphthoquinone dye, an anthraquinone dye, a phthalocyanine dye, a carbonium dye, a diimonium compound, a quinoneimine dye, a methine dye, a cyanine dye, a squarylium coloring agent, a pyrylium salt, and a metal thiolate complex. Examples of dyes preferably used in the present invention include a cyanine-based coloring agent such as heptamethine cyanine coloring agent, an oxonol-based coloring agent such as pentamethine oxonol coloring agent, a phthalocyanine-based coloring agent, and dyes described in paragraphs "0124" to "0137" of JP2008-63554A.

Among the photothermal conversion materials used in the present invention, as pigments, it is possible to use commercially available pigments and pigments described in a color index (C. I.) handbook, "Latest handbook of pigments" (edited by Japan Pigment Technology Society, 1977), "Latest applied technology of pigment" (CMC, 1986), and "Technology of printing ink" (CMC, 1984). Examples of the pigments include pigments described in paragraphs "0122" to "0125" of JP2009-178869A.

Among these pigments, carbon black which will be described later is preferable.

Specific examples of carbon black include furnace black, thermal black, channel black, lamp black, acetylene black, and the like. One kind of these may be used singly, or two or more kinds thereof may be used in combination.

These carbon blacks can be used in the form of a color chip or a color paste obtained by dispersing carbon black in advance in nitrocellulose, a binder, or the like by using a dispersant if necessary, such that the carbon blacks are easily dispersed. From the viewpoint of costs, it is preferable to use carbon black in the form of powder.

In the present invention, an average particle size of carbon black is preferably equal to or greater than 13 nm and equal to or less than 50 nm, more preferably equal to or greater than 15 nm and equal to or less than 40 nm, and particularly preferably equal to or greater than 15 nm and equal to or less than 31 nm, because then viscosity or processability of the composition for forming a first resin layer and processability become excellent.

The average particle size of carbon black is a number average particle size and measured using a transmission electron microcsope.

A nitrogen adsorption specific surface area (hereinafter, abbreviated to "N₂SA") of carbon black is preferably equal to or greater than 25 m²/g and equal to or less than 180 m²/g. N₂SA of carbon black used is more preferably equal to or greater than 30 m²/g and equal to or less than 160 m²/g, and particularly preferably equal to or greater than 40 m²/g and equal to or less than 150 m²/g.

N₂SA of carbon black is determined based on JIS K6217-2: 2001.

As the aforementioned carbon black, carbon black for rubber can be used. Specific examples thereof include SAF, SAF-HS, ISAF, ISAF-LS, ISAF-HS, IISAF, IISAF-HS, HAF, HAF-HS, HAF-LS, LI-HAF, FEF, FEF-HS, MAF, MAF-HS, T-NS, and the like. One kind of these may be used singly, or two or more kinds thereof may be used in combination.

Specifically, commercially avaialble carbon black described below can be used, but the present invention is not limited thereto. The numbers in each parenthesis represent an average particle size (nm) and a nitrogen adsorption specific surface area (m²/g) in this order.

Examples of carbon black manufactured by ASAHI CARBON CO., LTD. include ASAHI #78 (22 nm, 124 m²/g), ASAHI #80 (22 nm, 115 m²/g), ASAHI #70 (28 nm, 77 m²/g), ASAHI #70L (27 nm, 84 m²/g), ASAHI F-200 (38 nm, 51 m²/g), ASAHI #66 (44 nm, 43 m²/g), ASAHI #65 (44 nm, 42 m²/g), ASAHI #60HN (40 nm, 48 m²/g), ASAHI #60H (41 nm, 45 m²/g), ASAHI #60U (43 nm, 43 m²/g), ASAHI #60 (45 nm, 40 m²/g), ASAHI AX-015 (19 nm, 145 m²/g), and the like.

Examples of carbon black manufactured by NSCC Carbon Co., Ltd. include #300IH (19 nm, 120 m²/g), #300 (24 nm, 117 m²/g), #200IS (26 nm, 95 m²/g), #200 (29 nm, 75 m²/g), #200L (29 nm, 81 m²/g), #200IN (31 nm, 71 m²/g), #10 (40 nm, 49 m²/g), #10K (39 nm, 48 m²/g), #10S (42 nm, 53 m²/g), #100 (44 nm, 41 m²/g), and the like.

Examples of carbon black manufactured by Tokai Carbon Co., Ltd. include SEAST 9H (18 nm, 142 m²/g), SEAST 9 (19 nm, 142 m²/g), SEAST 7HM:N234 (19 nm, 126 m²/g), SEAST 6 (22 nm, 119 m²/g), SEAST 600 (23 nm, 106 m²/g), SEAST 5H (22 nm, 99 m²/g), SEAST KH:N339 (24 nm, 93 m²/g), SEAST 3H (27 nm, 82 m²/g), SEAST NH:N351 (29 nm, 74 m²/g), SEAST 3 (28 nm, 79 m²/g), SEAST N (29 nm, 74 m²/g), SEAST 300 (28 nm, 84 m²/g), SEAST 116HM (38 nm, 56 m²/g), SEAST 116 (38 nm, 49 m²/g), SEAST FM (50 nm, 42 m²/g), SEAST SO (43 nm, 42 m²/g), and the like.

Examples of carbon black manufactured by Mitsubishi Chemical Corporation include DIABLACK A (19 nm, 142 m²/g), DIABLACK N234 (22 nm, 123 m²/g), DIABLACK I (23 nm, 114 m²/g), DIABLACK LI (23 nm, 107 m²/g), DIABLACK II (24 nm, 98 m²/g), DIABLACK N339 (26 nm, 96 m²/g), DIABLACK SH (31 nm, 78 m²/g), DIABLACK H (31 nm, 79 m²/g), DIABLACK LH (31 nm, 84 m²/g), DIABLACK HA (32 nm, 74 m²/g), DIABLACK N550M (43 nm, 47 m²/g), DIABLACK E (48 nm, 41 m²/g), and the like.

As the aforementioned carbon black, carbon black for color can be used. Specifically, for example, the following commercially available carbon black can be used, but the present invention is not limited thereto. The numbers in each parenthesis represent an average particle size (nm) and a nitrogen adsorption specific surface area (m²/g) in this order.

Examples of carbon black manufactured by Mitsubishi Chemical Corporation include #1000 (18 nm, 180 m²/g), MCF88 (18 nm, 180 m²/g), MA600 (20 nm, 140 m²/g), #750B (22 nm, 124 m²/g), #650B (22 nm, 124 m²/g), #52 (27 nm, 88 m²/g), #47 (23 nm, 132 m²/g), #45 (24 nm, 120 m²/g), #45L (24 nm, 125 m²/g), #44 (24 nm, 110 m²/g), #40 (24 nm, 115 m²/g), #33 (30 nm, 85 m²/g), #32 (30 nm, 83 m²/g), #30 (30 nm, 74 m²/g), #25 (47 nm, 55 m²/g), #20 (50 nm, 45 m²/g), #95 (40 nm, 55 m²/g), #85 (40 nm, 60 m²/g), #260 (40 nm, 70 m²/g), MA77 (23 nm, 130 m²/g), MA7 (24 nm, 115 m²/g), MA8 (24 nm, 120 m²/g), MA11 (29 nm, 92 m²/g), MA100 (24 nm, 110 m²/g), MA100R (24 nm, 110 m²/g), MA100S (24 nm, 110 m²/g), MA230 (30 nm, 74 m²/g), MA14 (40 nm, 56 m²/g), and the like.

A content of the photothermal conversion material (particularly, carbon black) in the composition for forming a first resin layer is not particularly limited, but is preferably 0.1 to 30 parts by mass and more preferably 0.5 to 8 parts by mass with respect to 50 parts by mass of the diene-based polymer, because then sensitivity at the time of laser engraving and ink trapping properties become excellent.

### (Cross-linking agent)

The cross-linking agent contained in the composition for forming a first resin layer is not particularly limited, and for example, cross-linking agents known in the related art can be used. The cross-linking agent is preferably a compound (thermal cross-linking agent) that thermally cross-links diene-based polymers to each other, more preferably a vulcanizing agent, and even more preferably an organic peroxide or a sulfur-based compound.

### (A) Organic peroxide

Specific examples of the organic peroxide include dicumyl peroxide (10-hour half-life temperature: 116°C), α,α'-di(t-butylperoxy)diisopropylbenzene (10-hour half-life temperature: 119°C), 2,5-dimethyl-2,5-di(t-butylperoxy)hexane (10-hour half-life temperature: 118°C), and the like. One kind of these may be used singly, or two or more kinds thereof may be used in combination.

In the present invention, although the organic peroxide can be used in an undiluted form, in view of issues regarding handling (dangerousness, workability, and the like), it is possible to preferably use a diluted organic peroxide having a concentration of 40 wt% obtained by causing an undiluted organic peroxide to be adsorbed onto an inorganic filler such as calcium carbonate or a master batch-type diluted organic peroxide prepared for preventing dusting at the time of kneading or for improving dispersibility in a polymer.

As an undiluted organic peroxide, for example, it is possible to use PERCUMYL D (manufactured by NOF CORPORATION), PerkadoxBC-FF (manufactured by Kayaku Akuzo Corporation), LUPEROX DC (manufactured by ARKEMA Yoshitomi, Ltd.), PERBUTYL P (manufactured by NOF CORPORATION), PERKADOX 14 (manufactured by Kayaku Akuzo Corporation), LUPEROX F (manufactured by ARKEMA Yoshitomi, Ltd.), LUPEROX F90P (manufactured by ARKEMA Yoshitomi, Ltd.), PERHEXA 25B (manufactured by NOF CORPORATION), KAYAHEXA AD (manufactured by Kayaku Akuzo Corporation), LUPEROX 101 (manufactured by ARKEMA Yoshitomi, Ltd.), and the like, but the present invention is not limited to these.

As a diluted organic peroxide, for examples, it is possible to use PERCUMYL D-40 (manufactured by NOF CORPORATION: a diluted organic peroxide with an inert filler), PERCUMYL D-40MB (manufactured by NOF CORPORATION: a diluted organic peroxide with silica/polymer and others), KAYACUMYL D-40C (manufactured by Kayaku Akuzo Corporation: a diluted organic peroxide with calcium carbonate), KAYACUMYL D-40MB-S (manufactured by Kayaku Akuzo Corporation: rubber master batch), KAYACUMYL D-40MB (manufactured by Kayaku Akuzo Corporation: rubber master batch), PERBUTYL P-40 (manufactured by NOF CORPORATION: a diluted organic peroxide with an inert filler), PERBUTYL P-40MB (manufactured by NOF CORPORATION: a diluted organic peroxide with silica/polymer and others), PERKADOX 14/40 (manufactured by Kayaku Akuzo Corporation: a diluted organic peroxide with calcium carbonate), PERKADOX 14-40C (manufactured by Kayaku Akuzo Corporation: a diluted organic peroxide with calcium carbonate), LUPEROX F40 (manufactured by ARKEMA Yoshitomi, Ltd.), PERHEXA 25B-40 (manufactured by NOF CORPORATION: a diluted organic peroxide with silica and other), KAYAHEXA AD-40C (manufactured by Kayaku Akuzo Corporation: a diluted organic peroxide with calcium silicate), TRIGONOX 101-40MB (manufactured by Kayaku Akuzo Corporation: rubber master batch), LUPEROX 101XL (manufactured by ARKEMA Yoshitomi, Ltd.), and the like, but the present invention is not limited to these.

### (B) Sulfur-based compound

Examples of the sulfur-based compound include sulfur (elemental sulfur), sulfur chloride, sulfur dichloride, a mercapto compound, a sulfide compound, a disulfide compound, a polysulfide compound, a thiuram compound, a thiocarbamic acid compound, a polyfunctional mercapto compound, and the like. Among these, sulfur, sulfur chloride, sulfur dichloride, a disulfide compound, a thiuram compound, a thiocarbamic acid compound, and a polyfunctional mercapto compound are preferable.

Specific examples of the sulfur-based compound include sulfur, sulfur chloride, sulfur dichloride, morpholine disulfide, alkylphenol disulfide, tetramethylthiuram disulfide, selenium dimethyl dithiocarbamate, pentaerythritol tetrakis(3-mercaptobutyrate), pentaerythritol tetrakisthiopropionate, tris(3-mercaptobutyloxyethyl)isocyanurate, dipentaerythritol hexakisthiopropionate, and the like.

Among these, sulfur, alkylphenol disulfide, and pentaerythritol tetrakis(3-mercaptobutyrate) are preferable, and alkylphenol disulfide and pentaerythritol tetrakis(3-mercaptobutyrate) are more preferable.

A content of a cross-linking agent in the composition for forming a first resin layer is not particularly limited, but is preferably 0.1 to 10 parts by mass, more preferably 1 to 4 parts by mass, and even more preferably 1 to 2 parts by mass, with respect to 50 parts by mass of the diene-based polymer.

### (Optional components)

The composition for forming a first resin layer may contain components other than the aforementioned components. Examples of the components include a solvent, a cross-linking aid, a silane coupling agent, a filler, wax, process oil, a metal oxide, an antiozonant, an antioxidant, a polymerization inhibitor, a coloring agent, a polymerizable compound, a polymerization initiator, and the like.

### (A) Polymerizable compound

A polymerizable compound is preferably a compound having an ethylenically unsaturated bond (hereinafter, referred to as an "ethylenically unsaturated compound" as well).

The aforementioned ethylenically unsaturated compound may be a monofunctional ethylenically unsaturated compound or a polyfunctional ethylenically unsaturated compound, but is preferably a polyfunctional ethylenically unsaturated compound. Specifically, as the polyfunctional ethylenically unsaturated compound, a compound having 2 to 20 ethylenically unsaturated groups on a terminal is preferable. Such a compound group is widely known in the field of the related art, and those compounds can be used in the present invention without particular limitation.

The aforementioned ethylenically unsaturated compound is preferably an ethylenically unsaturated compound which is other than the aforementioned diene-based polymer and has a molecular weight of less than 1,000.

Examples of compounds from which the ethylenically unsaturated group in the polyfunctional ethylenically unsaturated compound is derived include unsaturated carboxylic acid (for example, acrylic acid, methacrylic acid, itaconic acid, crotonic acid, isocrotonic acid, or maleic acid) and esters and amides thereof. Among these, esters of unsaturated carboxylic acid and an aliphatic polyhydric alcohol compound and amides of unsaturated carboxylic acid and an aliphatic polyamine compound are preferably used.

Furthermore, a product of an addition reaction between an unsaturated carboxylic acid ester, which has a nucleophilic substituent such as a hydroxy group or an amino group, or amides and polyfunctional isocyanates or epoxies, a product of a dehydrocondensation reaction with polyfunctional carboxylic acid, and the like are preferably used.

In addition, a product of an addition reaction between an unsaturated carboxylic acid ester, which has an electrophilic substituent such as an isocyanate group or an epoxy group, or amides and monofunctional or polyfunctional alcohols or amines, and a product of a substitution reaction between an unsaturated carboxylic acid ester, which has a separable substituent such as a halogen group or a tosyloxy group, or amides and monofunctional or polyfunctional alcohols or amines are also preferable.

As other examples, instead of the aforementioned unsaturated carboxylic acid, a group of compounds substituted with a vinyl compound, an allyl compound, unsaturated phosphonic acid, styrene, or the like can also be used.

From the viewpoint of reactivity, as the ethylenically unsaturated compound, an acrylate compound, a methacrylate compound, a vinyl compound, and an allyl compound are preferable.

Examples of the allyl compound include polyethylene glycol diallyl ether, 1,4-cyclohexane diallyl ether, 1,4-diethylcyclohexyl diallyl ether, 1,8-octanediallyl ether, trimethylolpropane diallyl ether, trimethylolethane triallyl ether, pentaerythritol triallyl ether, pentaerythritol tetraallyl ether, dipentaerythritol pentaallyl ether, dipentaerythritol hexaallyl ether, diallyl phthalate, diallyl terephthalate, diallyl isophthalate, triallyl isocyanurate, triallyl cyanurate, triallyl phosphate, and the like.

Among these, triallyl isocyanurate and triallyl cyanurate are particularly preferred as the allyl compound.

Specific examples of a monomer of an ester of an aliphatic polyhydric alcohol compound and unsaturated carboxylic acid include acrylic acid esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl)isocyanurate, a polyester acrylate oligomer, and the like.

Examples of the aforementioned monomer include methacrylic acid esters such as tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethyl methane, bis[p-(methacryloxyethoxy)phenyl]dimethyl methane, and the like.

Examples of the aforementioned monomer include itaconic acid esters such as ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, and the like.

Examples of the aforementioned monomer include crotonic acid esters such as ethylene glycol dicrotonate, tetramethylene glycol dicrotonate, pentaerythritol dicrotonate, sorbitol tetracrotonate, and the like.

Examples of the aforementioned monomer include isocrotonic acid esters such as ethylene glycol diisocrotonate, pentaerythritol diisocrotonate, sorbitol tetraisocrotonate, and the like.

Examples of the aforementioned monomer include maleic acid esters such as ethylene glycol dimaleate, triethylene glycol dimaleate, pentaerythritol dimaleate, sorbitol tetramaleate, and the like.

As other esters, for example, aliphatic alcohol-based esters described in JP1971-27926B (JP-S46-27926B), JP1976-47334B (JP-S51-47334B), and JP1982-196231A (JP-S57-196231A), esters having an aromatic skeleton described in JP1984-5240A (JP-S59-5240A), JP1984-5241A (JP-S59-5241A), and JP1990-226149A (JP-H02-226149A), esters containing an amino group descried in JP1989-165613A (JP-H01-165613A), and the like are preferably used.

The above ester monomers can be used as a mixture.

Specific examples of a monomer of amide of an aliphatic polyamine compound and unsaturated carboxylic acid include methylene bisacrylamide, methylene bismethacrylamide, 1,6-hexamethylene bisacrylamide, 1,6-hexamethylene bismethacrylamide, diethylene triamine trisacrylamide, xylylene bisacrylamide, xylylene bismethacrylamide, and the like.

Examples of other preferred amide-based monomers include those having a cyclohexylene structure described in JP1979-21726B (JP-S54-21726B).

Furthermore, a urethane-based addition polymerizable compound manufactured using an addition reaction between isocyanate and a hydroxyl group is also preferable, and specific examples thereof include a vinyl urethane compound descried in JP1973-41708B (JP-S48-41708B) that is obtained by adding a hydroxyl group-containing vinyl monomer represented by the following Formula (i) to a polyisocyanate compound having two or more isocyanate groups in one molecule and contains two or more polymerizable vinyl groups in one molecule, and the like.

CH2=C(R)COOCH₂CH(R')OH (i)

### (Here, each of R and R' represents H or CH₃.)

In addition, urethane acrylates described in JP1976-37193A (JP-S51-37193A), JP1990-32293B (JP-H02-32293B), and JP1990-16765B (JP-H02-16765B) or urethane compounds having an ethylene oxide-based skeleton described in JP1983-49860B (JP-S58-49860B), JP1981-17654B (JP-S56-17654B), JP1987-39417B (JP-S62-39417B), and JP-1987-39418B (JP-S62-39417B) are also preferable.

Moreover, by using addition polymerizable compounds described in JP1988-277653A (JP-S63-277653A), JP1988-260909A (JP-S63-260909A), and JP1989-105238A (JP-H01-105238A) having an amino structure in a molecule, a cured composition can be obtained within a short period of time.

Examples of other ethylenically unsaturated compounds include polyester acrylates described in JP1973-64183A (JP-S48-64183A), JP1974-43191B (JP-S49-43191B), and JP1977-30490B (JP-S52-30490B), polyfunctional acrylate or methacrylate such as epoxy acrylates obtained by reacting (meth)acrylic acid with an epoxy resin, specific unsaturated compounds described in JP1971-43946B (JP-S46-43946B), JP1989-40337B (JP-H01-40337B), and JP1989-40336B (JP-H01-40336B), vinyl phosphonate-based compounds described in JP1990-25493A (JP-H02-25493A), and the like. In some cases, a structure containing a perfluoroalkyl group described in JP1986-22048A (JP-S61-22048A) is preferably used. In addition, those introduced as photocurable monomers and oligomers in Journal of The Adhesion Society of Japan, vol. 20, No. 7, pp. 300∼308 (1984) can also be used.

Examples of the ethylenically unsaturated compound include vinyl compounds such as butanediol-1,4-divinyl ether, ethylene glycol divinyl ether, 1,2-propanediol divinyl ether, 1,3-propanediol divinyl ether, 1,3-butanediol divinyl ether, 1,4-butanediol divinyl ether, neopentyl glycol divinyl ether, trimethylolpropane trivinyl ether, trimethylolethane trivinyl ether, hexanediol divinyl ether, tetraethylene glycol divinyl ether, pentaerythritol divinyl ether, pentaerythritol trivinyl ether, pentaerythritol tetravinyl ether, sorbitol tetravinyl ether, sorbitol pentavinyl ether, ethylene glycol diethylene vinyl ether, ethylene glycol dipropylene vinyl ether, trimethylolpropane triethylene vinyl ether, trimethylolpropane diethylene vinyl ether, pentaerythritol diethylene vinyl ether, pentaerythritol triethylene vinyl ether, pentaerythritol tetraethylene vinyl ether, 1,1,1-tris[4-(2-vinyloxyethoxy)phenyl]ethane, bisphenol A divinyloxyethyl ether, and divinyl adipate.

The composition for forming a first resin layer may contain only one kind of ethylenically unsaturated compound described above or two or more kinds thereof.

A content of the ethylenically unsaturated compound is preferably 0.1 to 30% by mass and more preferably 1 to 20% by mass, with respet to a total mass of the composition for forming a first resin layer.

### (B) Polymerization initiator

In a case where the composition for forming a first resin layer contains a polymerizable compound (particularly, an ethylenically unsaturated compound), it is preferable to use a polymerization initiator in combination.

As the polymerization initiator, polymerization initiators know in the related art can be used without limitation.

The polymerization initiator may be a radical polymerization initiator or a cation polymerization initiator, but is preferably a radical polymerization initiator.

Furthermore, the polymerization initiator may be a thermal polymerization initiator or a photopolymerization initiator, but is preferably a thermal polymerization initiator.

### (Method for preparing composition for forming first resin layer)

A method for preparing the composition for forming a first resin layer is not particularly limited, and examples thereof include a method of mixing and stirring the aforementioned components together, and the like.

### (Method for forming first resin layer precursor layer)

A method for forming the first resin layer precursor layer by using the composition for forming a first resin layer is not particularly limited, and examples thereof include a method of forming the composition for forming a first resin layer into a sheet by using a calendar roller, a method of coating a substrate such as a PET film with the composition for forming a first resin layer and then removing the solvent by drying the composition, and the like.

A thickness of the first resin layer precursor layer is not particularly limited as long as the cross-linked first resin layer has a thickness of equal to or less than 0.03 mm. The thickness of the first resin layer precursor layer is preferably 0.001 to 0.03 mm, and particularly preferably equal to or less than 0.02 mm.

### <Step (2): second resin layer precursor layer forming step>

The second resin layer precursor layer forming step is a step of forming a second resin layer precursor layer (second resin sheet) by using a composition for forming a second resin layer containing a diene-based polymer, a photothermal conversion agent, and a cross-linking agent.

The definition, specific examples, and preferred aspects of each of the components contained in the composition for forming a second resin layer are the same as those of the composition for forming a first resin layer.

In the composition for forming a second resin layer, a content of the diene-based polymer is preferably 5 to 90% by mass, more preferably 15 to 85% by mass, and even more preferably 30 to 80% by mass, with respect to a total amount of nonvolatile components (having a boiling point of equal to or higher than 120°C). It is preferable that the content of the diene-based polymer is within the above range, because then rinsing properties of engraving residues become excellent, and a relief layer having excellent ink transferability is obtained.

A content of the photothermal conversion agent (particularly, carbon black) in the composition for forming a second resin layer is not particularly limited, but is preferably 0.1 to 30 parts by mass and more preferably 0.5 to 8 parts by mass, with respect to 50 parts by mass of the diene-based polymer.

A content of the cross-linking agent in the composition for forming a second resin layer is not particularly limited, but is preferably 10 to 50 parts by mass, more preferably 20 to 50 parts by mass, and even more preferably 30 to 50 parts by mass, with respect to 50 parts by mass of the diene-based polymer.

Specific examples and preferred aspects of the method for preparing the composition for forming a second resin layer are the same as those of the method for preparing the composition for forming a first resin layer.

Specific examples and preferred aspects of the method for forming the second resin layer precursor layer are the same as those of the method for forming the first resin layer precursor layer.

### <Step (3): relief forming layer forming step>

The relief forming layer forming step is a step of forming a relief forming layer by bonding the first resin layer precursor layer and the second resin layer precursor layer to each other. A method for bonding the first resin layer precursor layer and the second resin layer precursor layer to each other is not particularly limited.

### <Step (4): cross-linking step>

The cross-linking step is a step of cross-linking the relief forming layer by heating so as to form a cross-linked relief forming layer. In the cross-linking step, the diene-based polymer in the relief forming layer is cross-linked by a cross-linking agent, and as a result, a cross-linked relief forming layer (the first resin layer + the second resin layer) is formed. The first resin layer is a layer obtained by cross-linking the first resin layer precursor layer, and the second resin layer is a layer obtained by cross-linking the second resin layer precursor layer.

As a method for cross-linking the relief forming layer, from the viewpoint of making it possible for the relief forming layer to be uniformly cured (cross-linked) from the surface to the inside, cross-linking is performed by means of heat (thermal cross-linking).

By the cross-linking of the relief forming layer, first, an advantage that a relief formed after laser engraving becomes sharp is obtained, and second, an advantage that adhesiveness of engraving residues generated at the time of laser engraving is suppressed is obtained. If an uncross-linked relief forming layer is laser-engraved, due to residual heat propagating to the periphery of a portion irradiated with the laser, an undesired portion is easily melted and easily deforms, and hence a sharp relief is not obtained in some cases.

Examples of facilities for thermal cross-linking include a hot air heating furnace, a heat press machine (a sheet feeding-type heat press machine or a continuous press conveyor), a heating roller, and the like, but the facilities are not particularly limited. In a case where the relief forming layer is cross-linked after being cut with a cutter in a desired size before the cross-linking step, a sheet feeding-type heat press machine may be used.

The heating temperature is preferably 100°C to 200°C, more preferably 120°C to 190°C, and particularly preferably 140°C to 180°C. The heating time is preferably 1 minute to 100 minutes, more preferably 3 minutes to 60 minutes, and particularly preferably 5 minutes to 30 minutes.

At the time of heating, the relief forming layer may be heated in a pressed state. At this time, in view of accuracy of the thickness, the pressure is preferably 1 MPa to 20 MPa and more preferably 3 MPa to 12 MPa. If the pressure is within this range, a pressure applied between templates of the press machine and reaction force such as elastic resiliency of the sheet against the pressure cancel out each other. Therefore, thermal cross-linking is performed in a state where a predetermined distance is maintained between the templates of the press machine, and hence the thickness of the relief forming layer practically does not change.

The cross-linking step may be performed in a state where only the relief forming layer exists or in a state where the relief forming layer has a sheet (film) on one surface or both surfaces thereof. For example, in a case where the relief forming layer forming step is performed in a state where the kneaded composition for forming a first resin layer is provided on a support, the relief forming layer provided with the support may be cross-linked as it is, or only the relief forming layer may be cross-linked after the support is peeled off. Furthermore, in a case where the relief forming layer is wound up in the form of a roller through a release sheet (film) after the relief forming layer forming step, the relief forming layer having the release sheet (film) may be cross-linked as it is, or only the relief forming layer may be cross-linked after the release sheet is peeled off. As the sheet (film) used in this case, it is possible to use the sheet (film) used as the support described in the aforementioned relief forming layer forming step.

### <Step (5): support bonding step>

The support bonding step is a step of bonding a support to the second resin layer side of the cross-linked relief forming layer so as to manufacture a flexographic printing plate precursor for laser engraving.

Specific examples and preferred aspects of the support to be bonded are as described above.

A method for bonding the support is not particularly limited, and examples of preferred aspects thereof include a method of bonding the support through an adhesive layer and the like. Specifically, examples thereof include a method of forming a photocurable layer by coating the second resin layer side of the cross-linked relief forming layer with a photocurable composition, bonding the support to the photocurable layer, and curing the photocurable layer through exposure, and the like. In this case, the obtained flexographic printing plate precursor for laser engraving includes the first resin layer, the second resin layer, the adhesive layer (cured photocurable layer), and the support.

As described above, in the precursor of the present invention, a ratio (D1/D2) of a dynamic hardness (D1) of the first resin layer to a dynamic hardness (D2) of the second resin layer is equal to or less than 0.3.

A method for making the ratio (D1/D2) equal to or less than 0.3 is not particularly limited, and examples thereof include a method of making a content of carbon black or a cross-linking agent in the composition for forming a second resin layer greater than a content of carbon black or a cross-linking agent in the composition for forming a first resin layer, and the like.

### [Flexographic printing plate]

The flexographic printing plate of the present invention is a flexographic printing plate obtained by laser-engraving the aforementioned precursor of the present invention.

A method for making the flexographic printing plate of the present invention is not particularly limited. The method preferably includes an engraving step of laser-engraving the precursor of the present invention so as to form a relief layer, and more preferably includes a rinsing step of rinsing a surface of the relief layer with an aqueous alkali solution so as to obtain a flexographic printing plate.

Hereinafter, each step will be described.

### [Engraving step]

The engraving step is a step of laser-engraving the cross-linked relief forming layer, which has been cross-linked in the aforementioned cross-linking step, so as to form a relief layer. Specifically, it is preferable to form a relief layer by performing engraving by means of irradiating the cross-linked relief forming layer with laser beams corresponding to a desired image. Examples of the engraving step preferably include a step of performing scan irradiation on the cross-linked relief forming layer by controlling a laser head through a computer based on digital data of a desired image.

In the engraving step, an infrared laser is preferably used. When the infrared laser is radiated, molecules in the cross-linked relief forming layer perform molecular vibration, and hence heat is generated. If a high-power laser such as a carbon dioxide laser or a YAG layer is used as the infrared laser, a large amount of heat is generated in the portion irradiated with the laser. As a result, molecules in the cross-linked relief forming layer undergo molecular cleavage or ionization and are selectively removed, that is, the relief forming layer is engraved. The laser engraving has an advantage that a structure can be three-dimensionally controlled because an engraving depth can be arbitrarily set. For example, in a portion on which fine halftone dots will be printed, by shallowly engraving the relief forming layer or engraving the relief forming layer while making a shoulder, it is possible to prevent the relief from being inverted due to the printing pressure. Furthermore, in a groove portion on which fine outline letters will be printed, by shallowly engraving the relief forming layer, it is possible to prevent the groove from being easily filled with ink and inhibit distortion of the outline letters.

Particularly, in a case where the relief forming layer is engraved with an infrared laser corresponding to an absorption wavelength of the photothermal conversion agent, the cross-linked relief forming layer can be selectively removed with higher sensitivity, and a relief layer having a sharp image can be obtained.

As the infrared laser used in the engraving step, in view of productivity, costs, and the like, a carbon dioxide laser (CO₂ laser) or a semiconductor laser is preferable. Particularly, a fiber coupled semiconductor infrared laser (FC-LD) is preferably used. Generally, compared to a CO₂ laser, the semiconductor laser has high laser oscillation efficiency and is cheap, and a size thereof can be reduced. Furthermore, because the semiconductor laser has a small size, an array thereof can be easily made. In addition, by treating fiber, the beam shape can be controlled.

A wavelength of the semiconductor laser is preferably 700 to 1,300 nm, more preferably 800 to 1,200 nm, even more preferably 860 to 1,200 nm, and particularly preferably 900 to 1,100 nm.

By additionally mounting optical fiber on the fiber coupled semiconductor laser, the laser can efficiently output laser beams. Therefore, the fiber coupled semiconductor laser is effective for the engraving step in the present invention. Furthermore, by treating fiber, the beam shape can be controlled. For example, a top-hat shape can be adopted as a beam profile, and in this way, energy can be stably applied to a surface of a plate. The semiconductor laser is specifically described in "Laser handbook, 2nd edition" edited by Laser Society of Japan, "Practical laser technology" by The Institute of Electronics, Information and Communication Engineers, and the like.

In addition, a printing plate making device which can be preferably used for making the flexographic printing plate of the present invention and includes the fiber coupled semiconductor laser is specifically described in JP2009-172658A and JP2009-214334A, and this device can be used for making the flexographic printing plate according to the present invention.

### [Rinsing step]

As described above, the method for making the flexographic printing plate of the present invention preferably includes a rinsing step of rinsing a surface of the relief layer with an aqueous alkali solution, after the engraving step. In the rinsing step, it is preferable to use an aqueous alkali solution as a rinsing solution. Through the rinsing step, engraving residues that adhere to and remain on the surface of the relief layer are washed off and removed.

Examples of means for rinsing include a method of dipping the relief layer into the aqueous alkali solution, a method of swirling the rinsing solution in a state where the relief layer is being dipped into the aqueous alkali solution, a method of scrubbing the engraved plate with a brush in a state where the engraved plate is being dipped into the aqueous alkali solution, a method of spraying the aqueous alkali solution, a method of the brushing the engraved surface mainly in the presence of the aqueous alkali solution by using a batch-type or transport-type brush-type washing machine known as a developing machine for a photosensitive resin relief printing plate, and the like. In a case where sliminess of engraving residues does not disappear, a rinsing solution to which a soap or a surfactant added may be used.

The pH of the rinsing solution (aqueous alkali solution) which can be used in the present invention is preferably equal to or greater than 10.0, more preferably equal to or greater than 12, and even more preferably equal to or greater than 13. Furthermore, the pH of the rinsing solution is preferably equal to or less than 14. If the pH is within the above range, rinsing properties become excellent.

In order to make the pH of the rinsing solution fall into the above range, the pH may be appropriately adjusted by using an acid and/or a base, and the acid and base to be used are not particularly limited.

The rinsing solution which can be used in the present invention preferably contains water as a main component.

The rinsing solution may contain, as a solvent other than water, a water miscible solvent such as alcohols, acetone, or tetrahydrofuran.

The rinsing solution preferably contains a surfactant.

From the viewpoint of removability of engraving residues and reducing an influence on the flexographic printing plate, examples of the surfactant which can be used in the present invention preferably include betaine compounds (amphoteric surfactants) such as a carboxybetaine compound, a sulfobetaine compound, a phosphobetaine compound, an amine oxide compound, and a phosphine oxide compound.

Examples of the surfactant include known anionic surfactants, cationic surfactants, amphoteric surfactants, nonionic surfactants, and the like. Furthermore, nonionic surfactants based on fluorine or silicone can also be used.

One kind of surfactant may be used singly, or two or more kinds thereof may be used in combination.

An amount of surfactant used does not need to be particularly limited, but is preferably 0.01 to 20% by mass and more preferably 0.05 to 10% by mass, with respect to a total mass of the rinsing solution.

If necessary, the method for making the flexographic printing plate of the present invention may further include a drying step and/or a post-cross-linking step.

### Drying step: a step of drying the engraved relief layer

Post-cross-linking step: a step of further cross-linking the relief layer by applying energy to the engraved relief layer

In a case where the rinsing step of rinsing the engraved surface is performed, it is preferable to additionally perform the drying step of drying the engraved relief layer so as to volatilize the rinsing solution.

Furthermore, if necessary, the post-cross-linking step of further cross-linking the relief layer may be additionally performed. If the post-cross-linking step as an additional cross-linking step is performed, the relief formed by engraving can be strengthened.

A flexographic printing plate including a relief layer and a support is obtained as above.

From the viewpoint of satisfying various printing suitability such as abrasion resistance or ink transferability, a thickness of the relief layer included in the flexographic printing plate is preferably equal to or greater than 0.5 mm and equal to or less than 10 mm, more preferably equal to or greater than 0.6 mm and equal to or less than 7 mm, and particularly preferably equal to or greater than 0.6 mm and equal to or less than 3 mm.

In a case where the relief layer has solid portions (non-engraved portions) and halftone dots, a difference between the solid portions and halftone dots (low-rise amount) is preferably 0.001 to 0.01 mm.

The flexographic printing plate of the present invention is particularly suitable for printing performed using a flexographic printing machine and an aqueous ink. However, in a case where a printing machine for relief printing plate and any of an aqueous ink, an oil-based ink, and a UV ink are used, printing can be performed on the flexographic printing plate of the present invention. Furthermore, printing can be performed on the flexographic printing plate of the present invention by using a flexographic printing machine and a UV ink.

### [Examples]

Hereinafter, the present invention will be more specifically described based on examples, but the present invention is not limited thereto.

### [Example 1]

### <Preparation of first resin layer precursor layer (first resin sheet)>

Three-neck flask equipped with a stirring blade and a cooling pipe was filled with 50 parts by mass of UBEPOL BR150 (polybutadiene, manufactured by UBE INDUSTRIES, LTD.) as a diene-based polymer and propylene glycol monomethyl ether acetate (PGMEA) as a solvent, followed by heating for 180 minutes at 70°C with stirring, thereby dissolving polybutadiene.

Then, 1 part by mass of carbon black #45 (manufactured by Mitsubishi Chemical Corporation) and 4 parts by mass of PERCUMYL D-40 (manufactured by NOF CORPORATION) as a cross-linking agent were added thereto, followed by stirring for 10 minutes. Through this operation, a coating solution (composition for forming a first resin layer) having fluidity was obtained.

On a PET substrate, a spacer frame having a predetermined thickness was installed, the coating solution obtained as above was carefully cast onto the substrate, and the substrate was heated for 3 hours in an oven with a temperature of 80°C, thereby removing the solvent. In this way, a first resin sheet was obtained. The preparation method described above is denoted by B.

### <Preparation of second resin layer precursor layer (second resin sheet)>

By using an MS-type compact pressurizing kneader (manufactured by MORIYAMA), 50 parts by mass of UBEPOL BR150 (polybutadiene, manufactured by UBE INDUSTRIES, LTD.) as a diene-based polymer and 5 parts by mass of carbon black #45 (manufactured by Mitsubishi Chemical Corporation) were kneaded for 10 minutes at 80°C with a front blade (35 rpm) and a rear blade (35 rpm). Then, the resultant was cooled to 60°C, 40 parts by mass of PERCUMYL D-40 (manufactured by NOF CORPORATION) as a cross-linking agent was added thereto, and the resultant was further kneaded for 10 minutes at 60°C with the front blade (20 rpm) and the rear blade (20 rpm), thereby obtaining a composition for forming a second resin layer.

The obtained composition for forming a second resin layer was shaped into a sheet by using calendar rollers (four inverted L-type rollers manufactured by Nippon Roll MFG.Co., Ltd.), thereby preparing a second resin sheet. Specifically, the composition for forming a second resin layer was preliminarily kneaded for 10 minutes at 50°C by using a warm-up roller, and the composition wound around the roller was cut midway through the kneading process, drawn out in the form of a sheet, and wound up in the form of a roll. The resultant was set between a first roller and a second roller of the calendar rollers and cast-molded. Regarding the temperature of each roller of the calendar rollers, a temperature of the first roller was set to be 50°C, a temperature of the second roller was set to be 60°C, a temperature of a third roller was set to be 70°C, and a temperature of a fourth roller was set to be 80°C. Furthermore, a roller interval was adjusted such that a thickness of the second resin layer in the obtained flexographic printing plate precursor for laser engraving became 0.88 mm. The transport rate was set to be 1 m/min.

### <Manufacturing flexographic printing plate precursor for laser engraving>

The obtained first resin sheet and the second resin sheet were each cut in a size of 20 cm (width) × 20 cm (length) and superposed on each other and then cross-linked by being heated for 20 minutes at 160°C under a pressure of 4 MPa by using a press machine (SA-303 manufactured by TESTER SANGYO CO., LTD.), thereby obtaining a cross-linked relief forming layer (the first resin layer + the second resin layer).

The second resin layer side of the obtained cross-linked relief forming layer was coated with a photocurable composition (manufactured by ThreeBond Holdings Co., Ltd.: 3030) such that an average film thickness became 80 µm, and then a PET film having thickness of 250 µm was bonded thereto as a support by using nip rollers. After 20 seconds, the photocurable layer was cured from the PET film side by using a UV exposure machine (a UV exposure machine ECS-151U manufactured by EYE GRAPHICS Co., Ltd., a metal halide lamp, 1,500 mJ/cm², exposure for 14 sec), thereby obtaining a flexographic printing plate precursor for laser engraving including the first resin layer, the second resin layer, and the PET film in this order.

For the obtained flexographic printing plate precursor for laser engraving, a dynamic hardness of the first resin layer and the second resin layer was evaluated. The evaluation method of the dynamic hardness is as described above. The dynamic hardness of the first resin layer and the second resin layer and a ratio (the aforementioned ratio (D1/D2)) of the dynamic hardness of the first resin layer to the dynamic hardness of the second resin layer are shown in Table 1.

### <Making flexographic printing plate>

The obtained flexographic printing plate precursor for laser engraving was raster-engraved from the first resin layer side by using a semiconductor laser, thereby obtaining a flexographic printing plate having an evaluation image (size: 50 mm × 50 mm, solid portion: 40 mm × 5 mm, halftone dot: 2 pix dot (resolution: 2,400 dpi)) shown in Fig. 2. As a semiconductor laser engraving machine, a laser recording device equipped with a fiber coupled semiconductor laser (FC-LD) SDL-6390 (manufactured by JDSU Corporation, wavelength: 915 nm) having a maximum power of 8.0 W was used (laser power: 7.5 W, head speed: 409 mm/sec, set pitch: 2,400 dpi).

### <Evaluation>

By using the obtained flexographic printing plate, printing was performed under the condition of an indentation amount of 20 µm and the condition of an indentation amount of 120 µm, and a density of solid portions and halftone dots was measured using a densitomter (manufactured by GretagMacbeth, MACBETH RD-19I). A printing pressure (indentation amount) under which the solid portions were uniformly printed was taken as a standard (0 µm).

### (Solid quality)

A flexographic printing plate in which the solid portions had a reflection density of equal to or greater than 1.8 under the condition of an indentation amount of 120 µm was regarded as having excellent solid quality and evaluated to be "A"; a flexographic printing plate in which the solid portions had a reflection density of equal to or greater than 1.7 and less than 1.8 was regarded as having fair solid quality and evaluated to be "B"; and a flexographic printing plate in which the solid portions had a reflection density of less than 1.7 was regarded as having poor solid quality and evaluated to be "C". The evaluation results are shown in Table 1. For practical use, he flexographic printing plate is preferably evaluated to be "A" or "B", and more preferably evaluated to be "A".

### (Printing pressure latitude)

A flexographic printing plate, in which a difference between a reflection density of halftone dots under the condition of an indentation amount of 20 µm and a reflection density of halftone dots under the condition of an indentation amount of 120 µm was less than 0.02, was regarded as having a wide printing pressure latitude and evaluated to be "A"; a flexographic printing plate in which the difference was equal to or greater than 0.02 and less than 0.05 was regarded as having a sightly wide printing pressure latitude and evalauted to be "B"; and a flexographic printing plate in which the difference was equal to or greater than 0.05 was regarded as having a narrow printing pressure latitude and evaluted to be "C". The evaluation results are shown in Table 1. For practical use, the flexographic printing plate is preferably evaluated to be "A" or "B", and more preferably evaluated to be "A".

### [Examples 2 to 11 and Comparative Examples 1 to 3]

A flexographic printing plate precursor for laser engraving and a flexographic printing plate were obtained according to the same procedure as in Example 1, except that, in preparing the first resin layer precursor and the second resin layer precursor, the type and formulated amount of the diene-based polymer in the composition for forming each resin layer, the formulated amount of carbon black, and the formulated amount of the cross-linking agent were changed as shown in Table 1, and the thickness of the spacer frame and the roller interval were changed such that the obtained flexographic printing plate precursor for laser engraving and each resin layer had a thickness shown in Table 1. In addition, various evalutions were performed. The results are shown in Table 1. Examples 3,4,7 shown in Table 1 are Reference Examples.

In Example 9, the first resin layer was prepared as below.

In Comparative Example 1, by preparing only the first resin layer and bonding a PET film to the first resin layer, a flexographic printing plate precursor for laser engraving was obtained.

In Comparative Example 2, by preparing only the second resin layer and bonding a PET film to the second resin layer, a flexographic printing plate precursor for laser engraving was obtained. Furthermore, in Comparative Example 2, by raster-engraving the flexographic printing plate precursor for laser engraving from the second resin layer side, a flexographic printing plate was obtained.

### <Preparation of first resin layer (first resin sheet) in Example 9>

By using an MS-type compact pressurizing kneader (manufactured by MORIYAMA), 50 parts by mass of UBEPOL BR150 (polybutadiene, manufactured by UBE INDUSTRIES, LTD.) and 5 parts by mass of carbon black #45 (manufactured by Mitsubishi Chemical Corporation) were kneaded for 10 minutes at 80°C with a front blade (35 rpm) and a rear blade (35 rpm). Then, the resultant was cooled to 60°C, 4 parts by mass of PERCUMYL D-40 (manufactured by NOF CORPORATION) as a cross-linking agent was added thereto, and the resultant was further kneaded for 10 minutes at 60°C with the front blade (20 rpm) and the rear blade (20 rpm), thereby obtaining a composition for forming a first resin layer.

The obtained composition for forming a first resin layer was shaped into a sheet by using calendar rollers (four inverted L-type rollers manufactured by Nippon Roll MFG.Co., Ltd.), thereby preparing a first resin layer. Specifically, the composition for forming a first resin layer was preliminarily kneaded for 10 minutes at 50°C by using a warm-up roller, and the composition wound around the roller was cut midway through the kneading process, drawn out in the form of a sheet, and wound up in the form of a roll. The resultant was set between a first roller and a second roller of the calendar rollers and cast-molded. Regarding the temperature of each roller of the calendar rollers, a temperature of the first roller was set to be 50°C, a temperature of the second roller was set to be 60°C, a temperature of a third roller was set to be 70°C, and a temperature of a fourth roller was set to be 80°C. Furthermore, a roller interval was adjusted such that a thickness of the first resin layer in the obtained flexographic printing plate precursor for laser engraving became 0.02 mm. The transport rate was set to be 1 m/min.

The preparation method described above is denoted by A.

Regarding the cross-linking agent (cross-linking agent used in the composition for forming a resin layer) in Table 1, the numerical values on the upper side represent a formulated amount of PERCUMYL D-40 (purity: 40% by mass) used, and the numerical values on the lower side (numerical values in the parenthesis) represent a net amount of the cross-linking agent.

Furthermore, the thickness in Table 1 represents a thickness of each resin layer in the obtained flexographic printing plate precursor for laser engraving.

**[Table 1]**

| Table 1 | First resin layer precursor layer | | | | | Second resin layer precursor layer | | | | Thickness | | Dynamic hardness | | | Evaluation | |
|---|---|---|---|---|---|---|---|---|---|---|---|---|---|---|---|---|
| | Diene-based polymer | | Carbon black | Cross-linking agent | Prepa ration method | Diene-based polymer | | Carbon black | Cross-linki ng agent | First resin layer | Second resin layer | First resin layer | Second resin layer | Ratio | Solid quality | Printing press ure latitude |
| | Type | Formulat ed amount | Formulat ed amount | Formulated amount | | Type | Formulat ed amount | Formulat ed amount | Formulated amount | [mm] | [mm] | [N/mm²] | [N/mm² ] | | | |
| Example 1 | BR | 50 parts by mass | 1 part by mass | 4 parts by mass (1.6 parts by mass) | B | BR | 50 parts by mass | 5 parts by mass | 40 parts by mass (16 parts by mass) | 0.02 | 0.88 | 2 | 8 | 0.25 | A | A |
| Example 2 | BR | 50 parts by mass | 5 parts by mass | 4 parts by mass (1.6 parts by mass) | B | BR | 50 parts by mass | 5 parts by mass | 40 parts by mass (16 parts by mass) | 0.02 | 0.88 | 2 | 8 | 0.25 | A | A |
| Example 3* | BR | 50 parts by mass | 10 parts by mass | 4 parts by mass (1.6 parts by mass) | B | BR | 50 parts by mass | 5 parts by mass | 40 parts by mass (16 parts by mass) | 0.02 | 0.88 | 3 | 8 | 0.38 | B | A |
| Example 4* | BR | 50 parts by mass | 20 parts by mass | 4 parts by mass (1.6 parts by mass) | B | BR | 50 parts by mass | 5 parts by mass | 40 parts by mass (16 parts by mass) | 0.02 | 0.88 | 3 | 8 | 0.38 | B | A |
| Example 5 | BR | 50 parts by mass | 5 parts by mass | 1 part by mass (0.4 parts by mass) | B | BR | 50 parts by mass | 5 parts by mass | 40 parts by mass (16 parts by mass) | 0.02 | 0.88 | 1 | 8 | 0.13 | A | A |
| Example 6 | BR | 50 parts by mass | 5 parts by mass | 4 parts by mass (1.6 parts by mass) | B | BR | 50 parts by mass | 5 parts by mass | 40 parts by mass (16 parts by mass) | 0.02 | 0.88 | 2 | 8 | 0.25 | A | A |
| Example 7* | BR | 50 parts by mass | 5 parts by mass | 20 parts by mass (8 parts by mass) | B | BR | 50 parts by mass | 5 parts by mass | 40 parts by mass (16 parts by mass) | 0.02 | 0.88 | 3 | 8 | 0.38 | B | A |
| Example 8 | BR | 50 parts by mass | 5 parts by mass | 4 parts by mass (1.6 parts by mass) | B | BR | 50 parts by mass | 5 parts by mass | 40 parts by mass (16 parts by mass) | 0.03 | 0.87 | 2 | 8 | 0.25 | A | B |
| Example 9 | BR | 50 parts by mass | 5 parts by mass | 4 parts by mass (1.6 parts by mass) | A | BR | 50 parts by mass | 5 parts by mass | 40 parts by mass (16 parts by mass) | 0.02 | 0.88 | 2 | 8 | 0.25 | A | A |
| Example 10 | EP DM | 50 parts by mass | 5 parts by mass | 4 parts by mass (1.6 parts by mass) | B | EP DM | 50 parts by mass | 5 parts by mass | 40 parts by mass (16 parts by mass) | 0.02 | 0.88 | 2 | 8 | 0.25 | A | A |
| Example 11 | IR | 50 parts by mass | 5 parts by mass | 4 parts by mass (1.6 parts by mass) | B | IR | 50 parts by mass | 5 parts by mass | 40 parts by mass (16 parts by mass) | 0.02 | 0.88 | 2 | 8 | 0.25 | A | A |
| Compara tive Example 1 | BR | 50 parts by mass | 5 parts by mass | 4 parts by mass (1.6 parts by mass) | B | - | - | - | - | 0.90 | - | 2 | - | - | A | C |
| Compara tive Example 2 | | | - | - | - | BR | 50 parts by mass | 5 parts by mass | 40 parts by mass (16 parts by mass) | - | 0.90 | - | 8 | - | C | A |
| Compara tive Example 3 | BR | 50 parts by mass | 5 parts by mass | 4 parts by mass (1.6 parts by mass) | B | BR | 50 parts by mass | 5 parts by mass | 40 parts by mass (16 parts by mass) | 0.04 | 0.86 | 2 | 8 | 0.25 | A | C |

| | | | | | | | | | | | | | | | | |
|---|---|---|---|---|---|---|---|---|---|---|---|---|---|---|---|---|
| *: Reference Examples | | | | | | | | | | | | | | | | |

In Table 1, details of the diene-based polymers are as below.
- BR: UBEPOL BR150 (polybutadiene, manufactured by UBE INDUSTRIES, LTD.)
- EPDM: MITSUI EPT1045 (ethylene-propylene-diene copolymer, ethylene content: 58% by mass, diene content: 5% by mass, type of diene: dicyclopentadiene (DCPD), manufactured by Mitsui Chemicals, Inc.)
- IR: Nipol IR2200 (polyisoprene, manufactured by ZEON CORPORATION)

As is evident from Table 1, a flexographic printing plate obtained from the flexographic printing plate precursor for laser engraving of examples of the present application had excellent solid quality and a wide printing pressure latitude. Among the examples, Examples 1 to 7 and 9 to 11, in which the first resin layer had a thickness of equal to or less than 0.02 mm, had a wide printing pressure latitude. Particularly, Examples 1, 2, 5, 6, and 9 to 11, in which a ratio of a dynamic hardness of the first resin layer to a dynamic hardness of the second resin layer was equal to or less than 0.3, had excellent solid quality. Examples 3,4,7 shown in Table 1 are Reference Examples.

In contrast, in Comparative Examples 1 and 2 in which the cross-linked relief forming layer consisted of only a single layer, solid quality was insufficient or a printing pressure latitude was narrow. Furthermore, Comparative Example 3, which included the first resin layer, the second resin layer, and the support in this order and in which a ratio of a dynamic hardness of the first resin layer to a dynamic hardness of the second resin layer was equal to or less than 0.9 and the first resin layer had a thickness of greater than 0.03 mm, had a narrow printing pressure latitude.

### Explanation of References

10: first resin layer
20: second resin layer
30: support
100: flexographic printing plate precursor for laser engraving

## Claims

1. A flexographic printing plate precursor for laser engraving comprising:
a first resin layer formed from a composition containing a diene-based polymer;
a second resin layer formed from a composition containing a diene-based polymer; and
a support in this order,
wherein a thickness of the first resin layer is equal to or less than 0.03 mm, and
a ratio of the dynamic hardness of the first resin layer to the dynamic hardness of the second resin layer is equal to or less than 0.3.

2. The flexographic printing plate precursor for laser engraving according to claim 1,
wherein a thickness of the first resin layer is equal to or less than 0.02 mm.

3. The flexographic printing plate precursor for laser engraving according to claim 1 or 2,
wherein the first resin layer is a resin layer obtained by cross-linking a composition for forming a first resin layer containing a diene-based polymer, a photothermal conversion agent, and a cross-linking agent, and
the second resin layer is a resin layer obtained by cross-linking a composition for forming a second resin layer containing a diene-based polymer, a photothermal conversion agent, and a cross-linking agent.

4. A flexographic printing plate obtained by laser-engraving the flexographic printing plate precursor for laser engraving according to any one of claims 1 to 3.

## Patentansprüche

1. Flexographie-Druckplattenvorläufer zum Lasergravieren, umfassend in dieser Reihenfolge:
eine erste Harzschicht, die aus einer Zusammensetzung gebildet ist, die ein Dien-basiertes Polymer enthält;
eine zweite Harzschicht, die aus einer Zusammensetzung gebildet ist, die ein Dien-basiertes Polymer enthält; und
einen Träger,
worin die Dicke der ersten Harzschicht gleich zu oder kleiner als 0,03 mm ist und
das Verhältnis der dynamischen Härte der ersten Harzschicht zur dynamischen Härte der zweiten Harzschicht gleich zu oder kleiner als 0,3 ist.

2. Flexographie-Druckplattenvorläufer zum Lasergravieren gemäß Anspruch 1, worin die Dicke der ersten Harzschicht gleich oder weniger als 0,02 mm beträgt.

3. Flexographie-Druckplattenvorläufer zum Lasergravieren gemäß Anspruch 1 oder 2,
worin die erste Harzschicht eine Harzschicht ist, die durch Vernetzen einer Zusammensetzung zum Bilden einer ersten Harzschicht erhalten wurde, enthaltend ein Dien-basiertes Polymer, ein Foto-Wärme-Umwandlungsmittel und ein Vernetzungsmittel, und
die zweite Harzschicht eine Harzschicht ist, die durch Vernetzen einer Zusammensetzung zum Bilden einer zweiten Harzschicht erhalten wurde, enthaltend ein Dien-basiertes Polymer, ein Foto-Wärme-Umwandlungsmittel und ein Vernetzungsmittel.

4. Flexographiedruckplatte, erhalten durch Lasergravieren des Flexographie-Druckplattenvorläufer zum Lasergravieren gemäß irgendeinem der Ansprüche 1 bis 3.

## Revendications

1. Précurseur de plaque d'impression flexographique pour la gravure au laser comprenant :
une première couche de résine formée à partir d'une composition contenant un polymère à base de diène ;
une deuxième couche de résine formée à partir d'une composition contenant un polymère à base de diène ; et
un support dans cet ordre,
dans lequel une épaisseur de la première couche de résine est égale à ou inférieure à 0,03 mm, et
un rapport de la dureté dynamique de la première couche de résine à la dureté dynamique de la deuxième couche de résine est égal à ou inférieur à 0,3.

2. Le précurseur de plaque d'impression flexographique pour la gravure au laser selon la revendication 1,
dans lequel une épaisseur de la première couche de résine est égale à ou inférieure à 0,02 mm.

3. Le précurseur de plaque d'impression flexographique pour la gravure au laser selon la revendication 1 ou 2,
dans lequel la première couche de résine est une couche de résine obtenue en réticulant une composition pour former une première couche de résine contenant un polymère à base de diène, un agent de conversion photothermique, et un agent de réticulation, et
la deuxième couche de résine est une couche de résine obtenue en réticulant une composition pour former une deuxième couche de résine contenant un polymère à base de diène, un agent de conversion photothermique, et un agent de réticulation.

4. Plaque d'impression flexographique obtenue par gravure au laser du précurseur de plaque d'impression flexographique pour la gravure au laser selon l'une quelconque des revendications 1 à 3.
